# FASCICULE DE BREVET EUROPEEN

(11) **EP 3 109 199 B1**
(45) Date de publication et mention de la délivrance du brevet: **11.05.2022**
(21) Numéro de dépôt: 16170668.4
(22) Date de dépôt: 20.05.2016
(51) Int. Cl.: G04B 17/06, G04B 19/12, G04B 37/22

(54) **PIECE A BASE DE SILICIUM AVEC AU MOINS UN CHANFREIN ET SON PROCEDE DE FABRICATION**
WERKSTÜCK AUF SILIZIUMBASIS MIT MINDESTENS EINER FASE, UND SEIN HERSTELLUNGSVERFAHREN
SILICON-BASED PART WITH AT LEAST ONE CHAMFER AND METHOD FOR MANUFACTURING SAME

(30) Priorité: 25.06.2015 EP 15173823
(43) Date de publication de la demande: 28.12.2016
(73) Titulaire: Nivarox-FAR S.A., 2400 Le Locle (CH)
(72) Inventeur: Gandelhman, Alex, 2000 Neuchâtel (CH)
(74) Mandataire: Collé, Emmanuel

(56) Documents cités:
- EP-A1- 2 840 059
- CH-A2- 699 476
- None

## Description

### Domaine de l'invention

L'invention se rapporte à un procédé de fabrication d'une pièce de micromécanique à base de silicium.

### Arrière-plan de l'invention

Le document CH 698 837 divulgue la fabrication d'un composant horloger par micro-usinage d'une plaquette en matériau amorphe ou cristallin tel que du silicium sous forme cristalline ou polycristalline.

Un tel micro-usinage est généralement obtenu à partir d'un gravage ionique réactif profond (connu également sous l'abréviation anglaise « DRIE »). Comme illustré aux figures 1 à 4, un micro-usinage connu consiste en une structuration d'un masque 1 sur un substrat 3 (cf. Figure 1, étape A) suivi d'un gravage ionique réactif profond du type « Bosch » combinant successivement une phase d'attaque (cf. figure 1, étapes B, D, E) suivie d'une phase de passivation (cf. figure 1, étape C, couche 4) pour obtenir, à partir du motif du masque 1, d'une gravure anisotrope 5, c'est-à-dire sensiblement verticale, dans la plaquette (cf. figure 2 et 4).

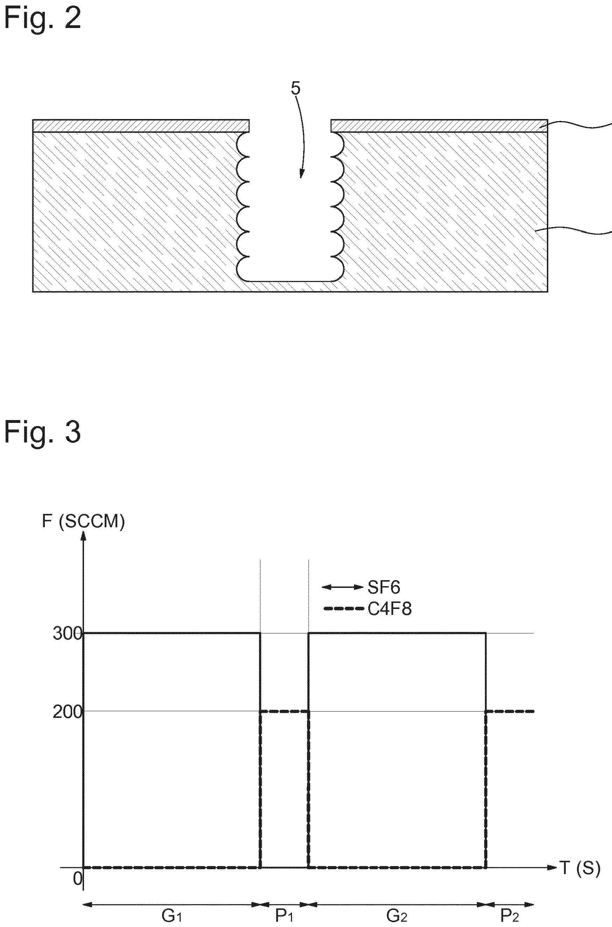

Comme illustré à la figure 3, un exemple de gravage ionique réactif profond du type « Bosch » est représenté avec, en trait plein, le flux en SCCM de SF₆ en fonction du temps en secondes permettant le gravage d'une plaquette en silicium et, en trait interrompu, le flux en SCCM de C₄F₈ en fonction du temps en secondes permettant la passivation, c'est-à-dire la protection, de la plaquette en silicium. On peut ainsi très bien voir que les phases sont strictement consécutives et comportent un flux et un temps qui leur sont propres.

Dans l'exemple de la figure 3, une première phase G₁ de gravage est représentée avec un flux de SF₆ à 300 SCCM pendant 7 secondes, suivie par une première phase P₁ de passivation avec un flux de C₄F₈ à 200 SCCM pendant 2 secondes, suivie d'une deuxième phase G₂ de gravage avec un flux de SF₆ à 300 SCCM à nouveau pendant 7 secondes et, enfin, suivie d'une deuxième phase P₂ de passivation avec un flux de C₄F₈ à 200 SCCM pendant 2 secondes, et ainsi de suite. On remarque donc qu'un certain nombre de paramètres permet de faire varier le gravage ionique réactif profond du type « Bosch » pour avoir une ondulation plus ou moins marquée de la paroi de la gravure verticale 5.

Après plusieurs années de fabrication, il s'est avéré que ces gravures 5 verticales n'étaient pas totalement satisfaisantes notamment en raison des bords à angle droit sensibles aux égrisures et du caractère « brut » des pièces obtenues.

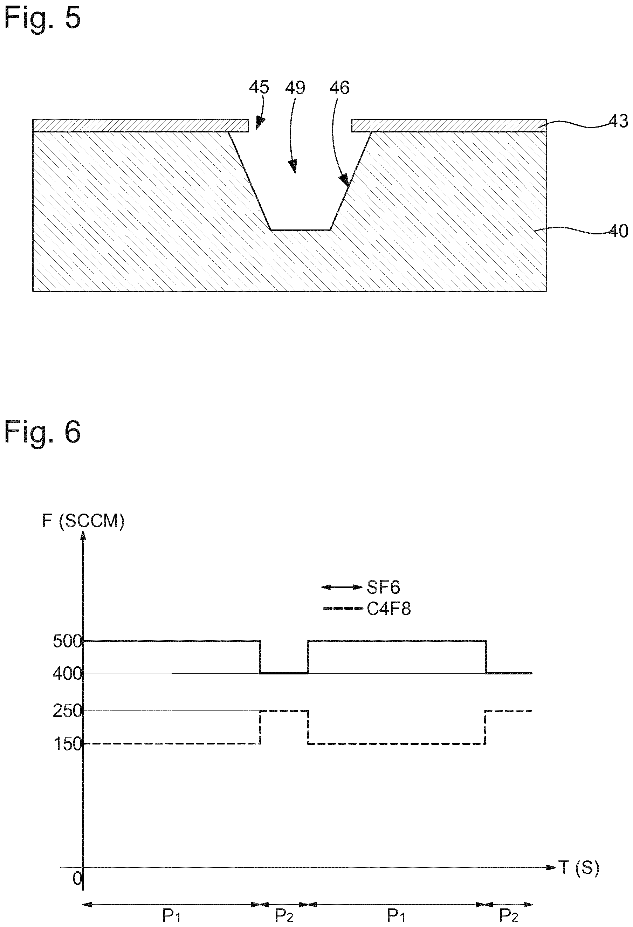

Le document EP 2 840 059 décrit une pièce de micromécanique en silicium comprenant un angle entre la surface verticale et la surface oblique inférieur à 10°. Ce document (cf. figure 6) décrit un procédé de fabrication d'une pièce de micromécanique selon le préambule de la revendication 1.

Le document CH 699 476 décrit une pièce de micromécanique en silicium comprenant une surface verticale suivie d'une surface arrondie.

### Résumé de l'invention

Le but de la présente invention est de pallier tout ou partie les inconvénients cités précédemment en proposant un nouveau type de pièce de micromécanique à base de silicium et un nouveau type de procédé de fabrication permettant notamment l'amélioration esthétique et l'amélioration de la tenue mécanique de pièces formées par micro-usinage d'une plaquette à base de silicium.

A cet effet, l'invention se rapporte à un procédé de fabrication d'une pièce de micromécanique à base de silicium comportant les étapes suivantes:
a) se munir d'un substrat à base de silicium ;
b) former un masque muni d'ajourages sur une partie horizontale du substrat ;
c) graver, dans une chambre de gravage, selon des parois obliques prédéterminées, dans une partie de l'épaisseur du substrat à partir des ajourages du masque afin de former des surfaces supérieures chanfreinées de la pièce de micromécanique ;
d) graver, dans la chambre de gravage, selon des parois sensiblement verticales, dans au moins une partie de l'épaisseur du substrat à partir du fond du premier gravage afin de former les parois périphériques de la pièce de micromécanique sous les surfaces supérieures chanfreinées ;
e) libérer la pièce de micromécanique du substrat et du masque,
le procédé comportant entre l'étape d) et l'étape e), les étapes suivantes :
f) former une couche de protection sur les parois obliques et les parois sensiblement verticales en laissant le fond de gravure de l'étape d) sans couche de protection ;
g) graver, dans la chambre de gravage, selon des parois obliques prédéterminées, dans le reste de l'épaisseur du substrat à partir du fond sans couche de protection afin de former des surfaces inférieures chanfreinées de la pièce de micromécanique, et
en ce que le procédé comporte avant l'étape e), l'étape suivante :
h) remplir une cavité formée lors des gravages de la pièce de micromécanique, formée par une surface supérieure chanfreinée, une paroi périphérique et une surface inférieure chanfreinée, d'un métal ou d'un alliage métallique afin d'offrir une attache à la pièce de micromécanique.

On comprend que, dans la même chambre de gravage, deux types distincts de gravage sont obtenus sans que le substrat soit retiré de la chambre. On comprend immédiatement que le gravage oblique de l'étape c) permet de s'affranchir des angles sensiblement droits entre respectivement les parois verticales périphériques ou internes gravées pour former plusieurs pièces de micromécanique sur le même substrat et les surfaces supérieure et inférieure du substrat. On peut également s'apercevoir que le gravage oblique de l'étape c) autorise un angle largement plus ouvert et une direction de gravure sensiblement rectiligne qui évite d'être limité par les paramètres d'un gravage ionique réactif profond du type « Bosch » qui est, en revanche, utilisé lors de l'étape d) selon ses paramètres optimisés de gravure verticale.

Conformément à d'autres variantes avantageuses de l'invention :
- l'étape c) est réalisée en mélangeant du gaz de gravage et du gaz de passivation dans la chambre de gravage afin de former des parois obliques ;
- lors de l'étape c), les flux continus des gaz de gravage et de passivation sont pulsés afin de favoriser la passivation en fond de cavité ;
- l'étape d) est réalisée en alternant un flux de gaz de gravage et un flux de gaz de passivation dans la chambre de gravage afin de former des parois sensiblement verticales ;
- l'étape g) est réalisée en mélangeant du gaz de gravage et du gaz de passivation dans la chambre de gravage afin de former des parois obliques ;
- lors de l'étape g), les flux continus des gaz de gravage et de passivation sont pulsés afin de favoriser le gravage en fond de cavité ;
- l'étape f) comporte les phases f1) : oxyder les parois obliques et les parois sensiblement verticales pour former la couche de protection en oxyde de silicium et f2) : graver de manière directionnelle la couche de protection afin de retirer sélectivement la partie de couche de protection uniquement au niveau du fond de gravure de l'étape d).

### Description sommaire des dessins

D'autres particularités et avantages ressortiront clairement de la description qui en est faite ci-après, à titre indicatif et nullement limitatif, en référence aux dessins annexés, dans lesquels :

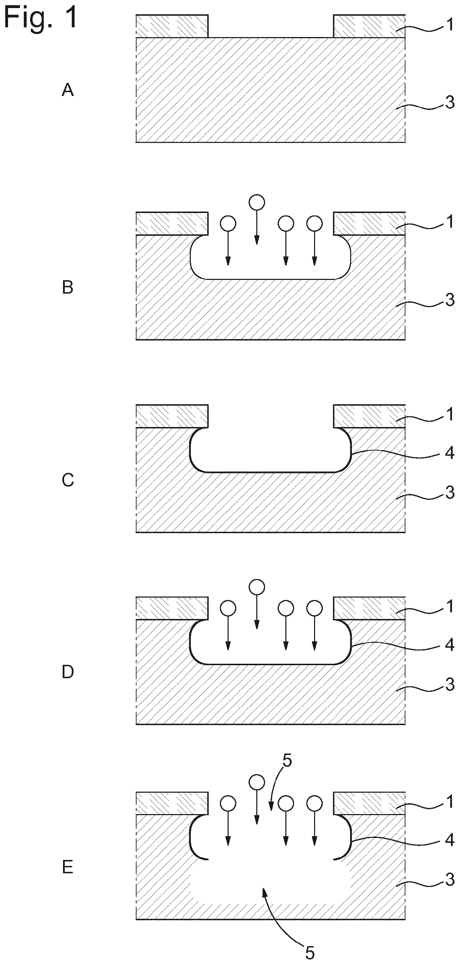

- les figures 1 à 4 sont des représentations destinées à expliquer le gravage ionique réactif profond du type « Bosch » utilisé dans le cadre de l'invention ;
- les figures 5 à 17 sont des représentations d'étapes de fabrication d'une pièce de micromécanique selon l'invention ;

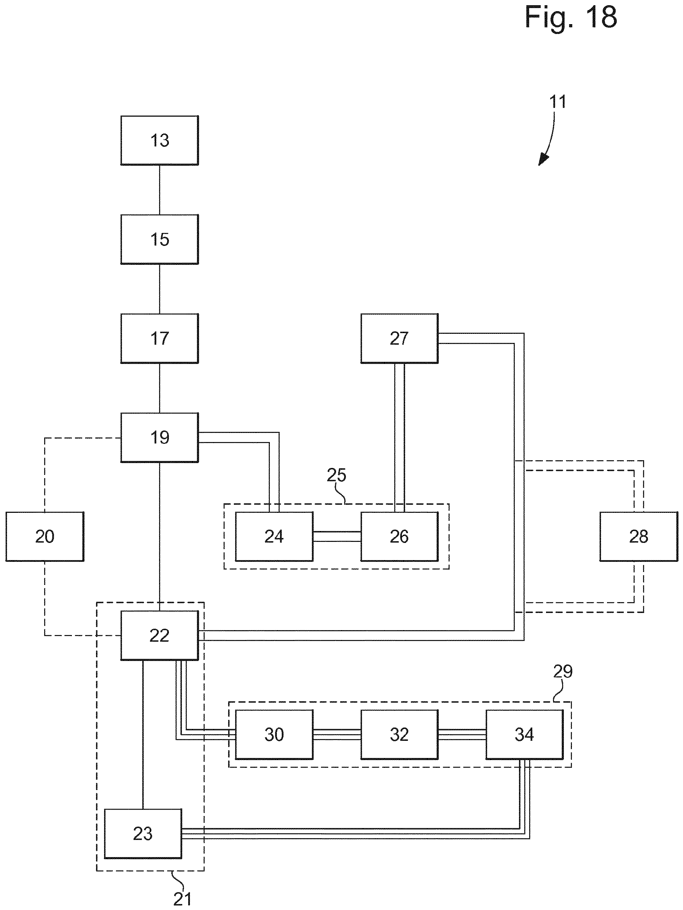

- la figure 18 est un schéma fonctionnel des procédés de fabrication selon l'invention.

### Description détaillée des modes de réalisation préférés

L'invention se rapporte à un procédé 11 de fabrication d'une pièce de micromécanique à base de silicium. Comme illustré à la figure 18, le procédé 11 comporte une première étape 13 destinée à se munir d'un substrat à base de silicium.

Les termes à base de silicium signifient un matériau comportant du silicium monocristallin, du silicium monocristallin dopé, du silicium polycristallin, du silicium polycristallin dopé, du silicium poreux, de l'oxyde de silicium, du quartz, de la silice, du nitrure de silicium ou du carbure de silicium. Bien entendu, quand le matériau à base de silicium est sous phase cristalline, n'importe quelle orientation cristalline peut être utilisée.

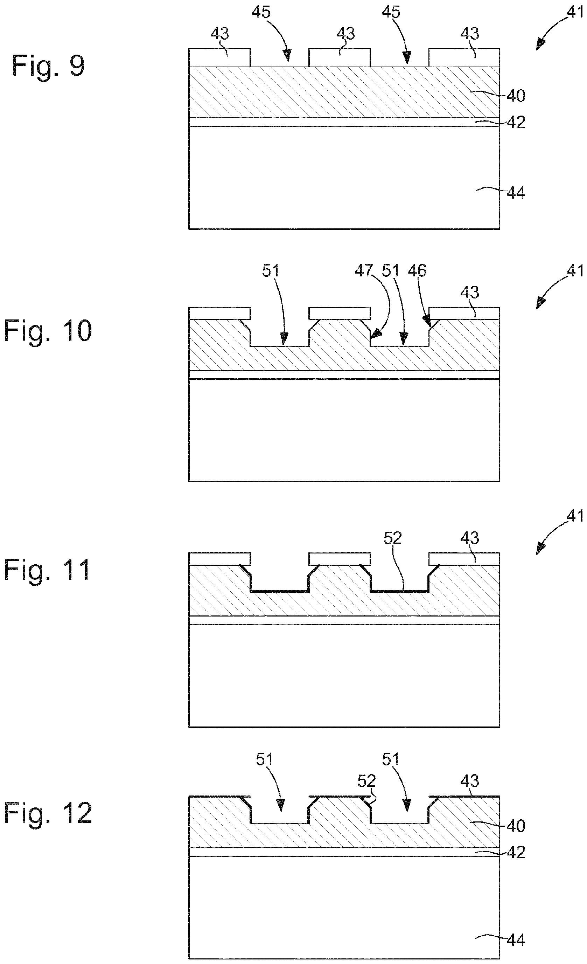

Typiquement, comme illustré à la figure 9, le substrat 41 à base de silicium peut être du silicium sur isolant (également connu sous l'abréviation anglaise « SOI ») comportant une couche supérieure 40 en silicium et une couche inférieure 44 en silicium reliées par une couche intermédiaire 42 en oxyde de silicium. Toutefois, alternativement, le substrat pourrait comporter une couche de silicium rapportée sur une autre type de base comme, par exemple, en métal.

Le procédé se poursuit avec l'étape 15 destinée à former un masque 43 muni d'ajourages 45 sur une partie horizontale du substrat 41. Dans l'exemple de la figure 9, le masque 43 est formé sur la partie supérieure de la couche supérieure 40 en silicium. Le masque 43 est formé à partir d'un matériau capable de résister aux futures étapes de gravage du procédé 11. A ce titre, le masque 43 peut être formé à partir de nitrure de silicium ou d'oxyde de silicium. Dans l'exemple de la figure 9, le masque 43 est formé à partir d'oxyde de silicium.

Le procédé se poursuit avec une étape 17 destinée à graver, à partir des ajourages 45 du masque 43, selon des parois 46 obliques prédéterminées, dans une partie de l'épaisseur du substrat 41 dans une chambre de gravage afin de former des surfaces supérieures chanfreinées de la pièce de micromécanique.

L'étape 17 de gravage oblique n'est pas un gravage ionique réactif profond du type « Bosch » décrit ci-dessus. En effet, l'étape 17 autorise un angle largement plus ouvert et une direction de gravure sensiblement rectiligne qui évitent d'être limités par les paramètres d'un gravage ionique réactif profond du type « Bosch ». En effet, on estime généralement que, même en modifiant les paramètres d'un gravage ionique réactif profond du type « Bosch », l'angle d'ouverture ne peut excéder 10 degrés en ayant une direction de gravure courbe.

En effet, comme visible aux figures 5 et 6, l'étape 17 est, avantageusement selon l'invention, réalisée en mélangeant du gaz SF₆ de gravage et du gaz C₄F₈ de passivation dans la chambre de gravage afin de former les parois 46 obliques. Plus précisément, les flux continus des gaz SF₆ de gravage et de passivation C₄F₈ sont préférentiellement pulsés afin de favoriser la passivation en fond de cavité.

On comprend donc l'étape 17 autorise un angle largement plus ouvert typiquement autour de 45 degrés dans l'exemple de la figure 5 au lieu des 10 degrés obtenus au mieux par un gravage ionique réactif profond du type « Bosch » avec une modification optimisée des paramètres. Avantageusement selon l'invention, l'étape 17 permet ainsi de donner un angle d'ouverture précis. L'angle entre les futures parois verticales 47 et les parois obliques 46 est très reproductible et peut être avantageusement compris entre sensiblement 0° et sensiblement 45°. Comme expliqué ci-dessus, c'est surtout la possibilité de graver selon un angle supérieur à 10° qui est remarquable par rapport à un gravage ionique réactif profond du type « Bosch ». Préférentiellement, l'angle selon l'invention entre les futures parois verticales 47 et les parois obliques 46 est supérieur à 10° et inférieur à 45°, et encore plus préféré, supérieur à 20° et inférieur à 40°.

De plus, la pulsation des flux continus autorise une meilleure directivité de gravure, voire obtenir des parois en tronc de cônes parfaits, et non sphériques (parfois appelés gravures isotropes) comme avec un gravage humide ou un gravage sec comme, par exemple, avec du gaz SF6 seul.

Pour obtenir la forme de parois 46 de la figure 5, on peut, par exemple, appliquer la séquence de la figure 6. Cette séquence comporte une première phase P₁ représentée avec un flux de SF₆ à 500 SCCM mélangé avec un flux de C₄F₈ à 150 SCCM pendant 1,2 seconde, suivie par une deuxième phase P₂ représentée avec un flux de SF₆ à 400 SCCM mélangé avec un flux de C₄F₈ à 250 SCCM pendant 0,8 seconde, suivie d'une troisième phase P₁ avec à nouveau un flux de SF₆ à 500 SCCM mélangé avec un flux de C₄F₈ à 150 SCCM pendant 1,2 seconde et suivie d'une quatrième phase P₂ avec un flux de SF₆ à 400 SCCM mélangé avec un flux de C₄F₈ à 250 SCCM pendant 0,8 seconde et ainsi de suite.

On remarque donc que cette pulsation des flux continus favorise la passivation en fond de cavité ce qui va restreindre, au fur et à mesure de l'étape 17, l'ouverture possible de la gravure 49 en fonction de sa profondeur et, incidemment, une ouverture de gravure 49 plus large au niveau de la partie supérieure de la couche supérieure 40 jusqu'à commencer à obtenir une ouverture de gravure 49 plus large que l'ajourage 45 au niveau de la partie supérieure de la couche supérieure 40 comme visible à la figure 5.

Le procédé 11 continue avec l'étape 19 destinée à graver, dans la même chambre de gravage et avec le même masque 43, selon des parois 47 cette fois-ci sensiblement verticales, dans au moins une partie de l'épaisseur de la couche 40 du substrat 41 à partir du fond de la première gravure 49 afin de former les parois périphériques sensiblement verticales de la pièce de micromécanique sous les surfaces supérieures chanfreinées.

L'étape 19 de gravage sensiblement vertical est typiquement un gravage ionique réactif profond du type « Bosch » décrit ci-dessus, c'est-à-dire en alternant un flux de gaz de gravage et un flux de gaz de passivation dans la chambre de gravage afin de former des parois sensiblement verticales.

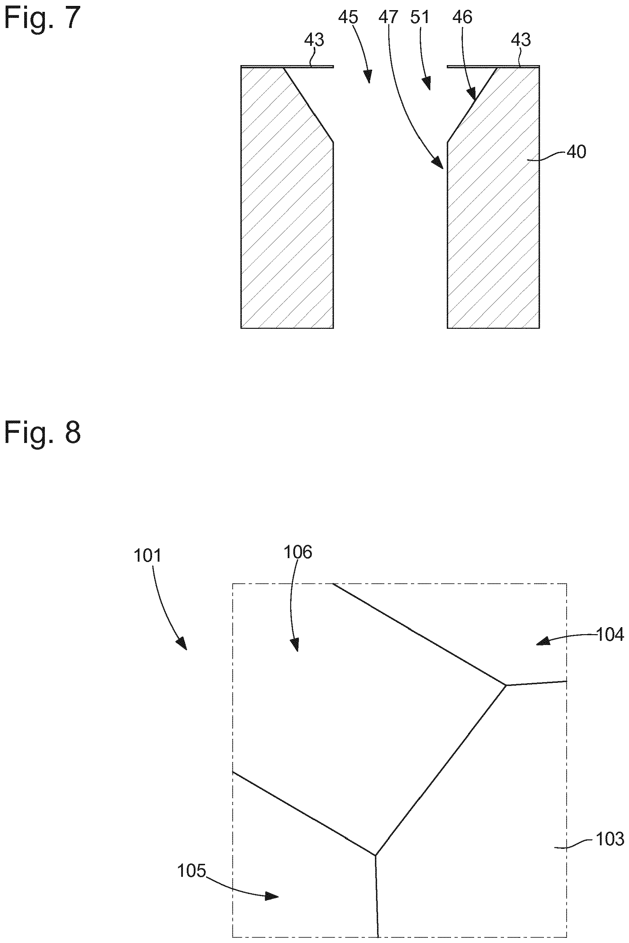

Ainsi, l'étape 19 autorise une direction de gravure sensiblement verticale par rapport au masque 43 comme visible à la figure 7 qui est une section obtenue après l'étape 19. On obtient ainsi une forme de section de gravure 51 dont la base forme sensiblement un quadrilatère droit suivi d'un évasement sensiblement conique.

Le procédé continue avec l'étape 21 destinée à libérer la pièce de micromécanique du substrat 41 et du masque 43. Plus précisément, dans l'exemple présenté à la figure 7, à réaliser une phase 22 de désoxydation permettant de retirer le masque 43 en oxyde de silicium et, éventuellement, une partie de la couche intermédiaire 42 en oxyde de silicium puis une phase 23 de libération du substrat 41 à l'aide, par exemple, d'une attaque chimique sélective.

Les étapes du procédé 11 illustré en trait simple à la figure 18 permet, dans une même chambre de gravage, deux types distincts de gravage sans que le substrat soit retiré de la chambre. On comprend immédiatement que le gravage oblique de l'étape 17 permet de s'affranchir des angles sensiblement droits entre respectivement les parois verticales périphériques et/ou internes gravées et les surfaces supérieure et inférieure de la couche 40 du substrat 41 pour former une ou plusieurs pièces de micromécanique sur le même substrat 41.

On peut également s'apercevoir que le gravage oblique de l'étape 17 autorise un angle largement plus ouvert et une direction de gravure sensiblement rectiligne qui évitent d'être limités par les paramètres d'un gravage ionique réactif profond du type « Bosch » et d'utiliser ce dernier lors de l'étape 19 selon ses paramètres optimisés de gravure verticale.

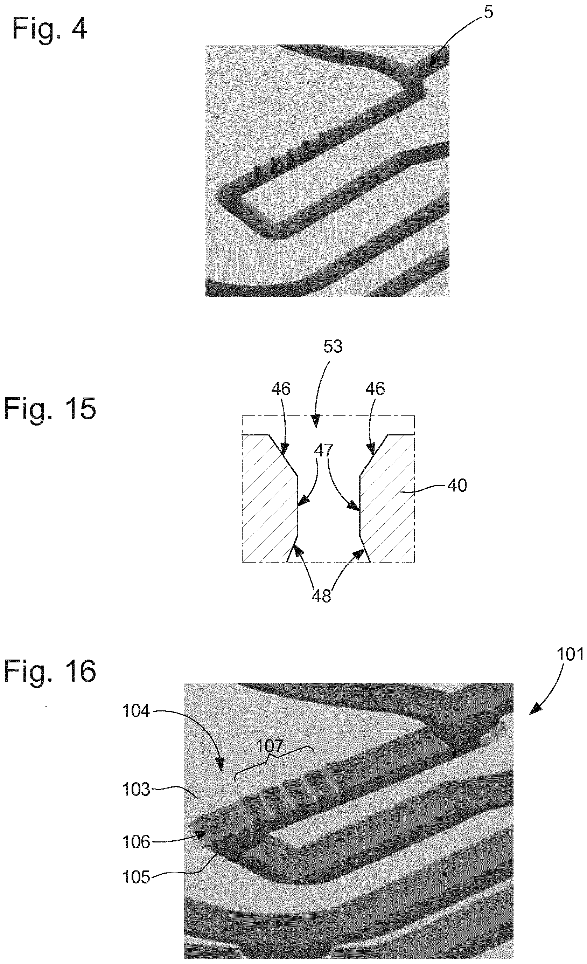

Avantageusement selon l'invention, la pièce de micromécanique 101 formant une ancre dans l'exemple de la figure 16 comporte une nette amélioration esthétique en offrant un rendu beaucoup plus travaillé. En effet, en comparaison avec la figure 4, on peut immédiatement détecter le caractère travaillé de la pièce de micromécanique 101.

Comme mieux visible à la figure 8 qui est une vue agrandie sur une partie de la pièce 101, la pièce de micromécanique 101 comporte ainsi un corps 103 à base de silicium dont la paroi périphérique verticale 105 borde une surface supérieure horizontale 104 par l'intermédiaire d'une surface supérieure chanfreinée 106.

On comprend donc la surface supérieure chanfreinée 106 sensiblement rectiligne apporte une amélioration de la tenue mécanique notamment en réduisant la possibilité d'égrisures des angles sensiblement droits entre respectivement les parois périphériques et/ou internes verticales 105 et les surfaces supérieure ou inférieure 104 de la pièce de micromécanique 101.

On comprend également que la paroi périphérique verticale 105 offre une réduction de sa surface de contact permettant d'apporter une amélioration quant à la tribologie contre une autre pièce ou quant à l'entrée d'une palette entre deux parois 105 de la pièce de micromécanique 101. Enfin, les décrochements des parois périphériques et/ou internes verticales 105 sont plus ouverts grâce à la surface supérieure chanfreinée 106 ce qui peut permettre notamment une augmentation de la capacité volumique à recevoir de la colle ou du lubrifiant comme dans le cas des décrochements 107 visibles à la figure 16 qui sont utilisés pour recevoir un matériau apte pour attacher une palette à l'ancre.

Le procédé de l'invention comporte, en outre, les étapes visibles en traits doubles à la figure 18.

Ainsi, après l'étape 19 formant la gravure 51, le procédé 11 se poursuit avec l'étape 25 destinée à former une couche de protection 52 sur les parois obliques 46 et les parois verticales 47 en laissant le fond de gravure 51 sans couche de protection comme visible à la figure 12.

Préférentiellement, la couche de protection 52 est formée en oxyde de silicium. En effet, comme visible aux figures 11 et 12, l'étape 25 peut alors comporter une première phase 24 destinée à oxyder tout le dessus du substrat 41, c'est-à-dire le masque 43 et les parois de la gravure 51 pour former une surépaisseur sur le masque 43 et une épaisseur sur les parois obliques 46, les parois verticales 47 et le fond de la gravure 51 pour former la couche de protection 52 en oxyde de silicium comme visible à la figure 11.

La deuxième phase 26 pourrait alors consister à graver, de manière directionnelle, la couche de protection 52 afin de retirer sélectivement les surfaces horizontales en oxyde de silicium d'une partie du masque 43 et de la totalité de la partie de couche de protection 52 uniquement au niveau du fond de la gravure 51 comme visible à la figure 12.

Le procédé 11 peut alors se poursuivre avec l'étape 27 destinée à graver, dans la chambre de gravage, selon des parois obliques 48 prédéterminées, dans le reste de l'épaisseur du substrat 41 à partir du fond sans couche de protection 52 afin de former des surfaces inférieures chanfreinées de la pièce de micromécanique.

L'étape 27 de gravage oblique, comme l'étape 17, n'est pas un gravage ionique réactif profond du type « Bosch » comme l'étape 19 décrit ci-dessus. Ainsi, l'étape 27 autorise, en combinaison de la couche de protection 52, un angle largement plus ouvert et une direction de gravure sensiblement rectiligne qui évite d'être limiter par les paramètres d'un gravage ionique réactif profond du type « Bosch ». En effet, on estime généralement que, même en modifiant les paramètres d'un gravage ionique réactif profond du type « Bosch », l'angle d'ouverture ne peut excéder 10 degrés en ayant une direction de gravure courbe.

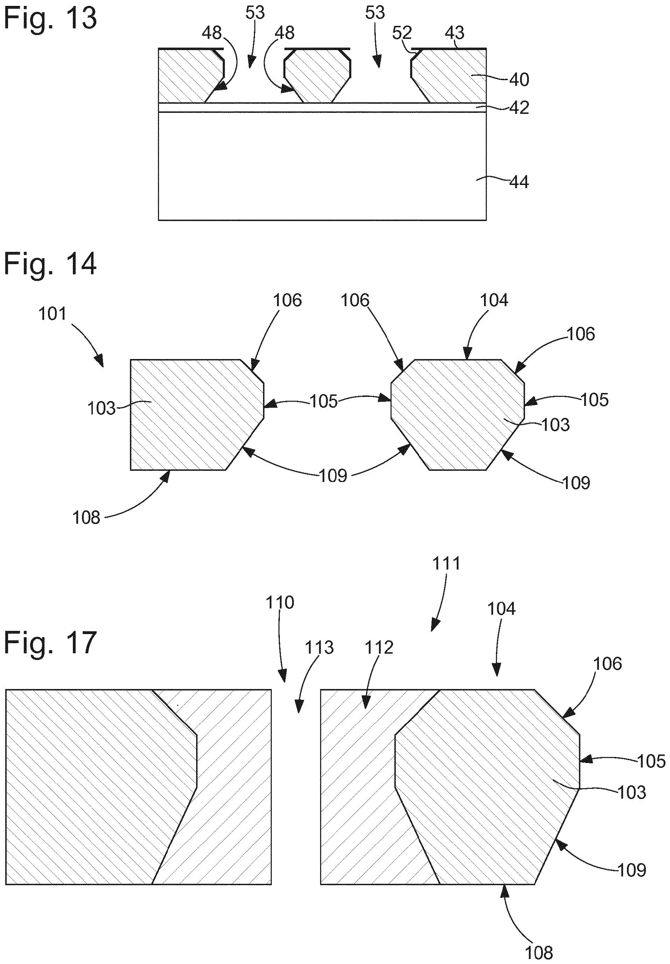

Par conséquent, comme visible aux figures 13 et 15, l'étape 27 est, avantageusement selon l'invention, réalisée en mélangeant du gaz SF₆ de gravage et du gaz C₄F₈ de passivation dans la chambre de gravage afin de former les parois 48 obliques. Plus précisément, les flux continus des gaz SF₆ de gravage et de passivation C₄F₈ sont préférentiellement pulsés afin de favoriser le gravage en fond de cavité.

On comprend donc l'étape 27 autorise un angle largement plus ouvert typiquement autour de 45 degrés dans l'exemple de la figure 13 au lieu des 10 degrés obtenus au mieux par un gravage ionique réactif profond du type « Bosch » avec une modification optimisée des paramètres. Avantageusement selon l'invention, l'étape 27 permet ainsi de donner un angle d'ouverture précis sans que les surfaces des parois obliques 46 et verticales 47 ne soient modifiées. L'angle entre les parois verticales 47 et les parois obliques 48 est très reproductible et peut être avantageusement compris entre sensiblement 0° et sensiblement 45°. Comme expliqué ci-dessus, c'est surtout la possibilité de graver selon un angle supérieur à 10° qui est remarquable par rapport à un gravage ionique réactif profond du type « Bosch ». Préférentiellement, l'angle selon l'invention entre les parois verticales 47 et les parois obliques 48 est supérieur à 10° et inférieur à 45°, et encore plus préféré, supérieur à 20° et inférieur à 40°.

De plus, la pulsation des flux continus autorise une meilleure directivité de gravure, voire obtenir des parois en tronc de cônes parfaits, et non sphériques (parfois appelés gravures isotropes) comme avec un gravage humide ou un gravage sec comme, par exemple, avec du gaz SF6 seul.

Pour obtenir la forme de parois 48 de la figure 13, on peut, par exemple, appliquer une séquence inverse à la figure 6. Cette séquence pourrait ainsi comporter une première phase avec un flux de SF₆ mélangé avec un flux de C₄F₈ pendant une première durée, suivie par une deuxième phase avec un flux augmenté de SF₆ mélangé avec un flux diminué de C₄F₈ pendant une deuxième durée, puis à nouveau les première et deuxième phase et ainsi de suite.

On remarque donc cette pulsation des flux continus favorise le gravage en fond de cavité ce qui va élargir, au fur et à mesure de l'étape 27, l'ouverture possible de la gravure 53 en fonction de sa profondeur et, incidemment, une ouverture de gravure 53 plus large au niveau de la partie inférieure de la couche supérieure 40 jusqu'à commencer à obtenir une ouverture de gravure 53 plus large que l'ajourage 45 du masque 43 et du fond de gravure 51 en début d'étape 27 comme visible à la figure 13 sans modifier la gravure 51 préalablement effectuée.

Dans l'exemple présenté à la figure 14 et 15, à réaliser une phase 21 de désoxydation permettant de retirer le masque 43 en oxyde de silicium, la couche de protection 52 et, éventuellement, tout ou partie de la couche intermédiaire 42 en oxyde de silicium comme illustré à la figure 13, puis une phase 23 de libération du substrat 41 à l'aide, par exemple, d'une attaque chimique sélective comme illustré à la figure 14.

On peut également s'apercevoir que le gravage oblique des étapes 17 et 27 autorise un angle largement plus ouvert et une direction de gravure sensiblement rectiligne qui évitent d'être limités par les paramètres d'un gravage ionique réactif profond du type « Bosch » et d'utiliser ce dernier lors de l'étape 19 selon ses paramètres optimisés de gravure verticale.

Avantageusement selon l'invention, la pièce de micromécanique 101, formant une ancre dans l'exemple de la figure 16, comporte une nette amélioration esthétique en offrant un rendu esthétique beaucoup plus travaillé. En effet, en comparaison avec la figure 4, on peut immédiatement détecter le caractère travaillé de la pièce de micromécanique 101 aussi bien sur la face supérieure 104 que sur la face inférieure 108.

Comme mieux visible aux figures 8 & 14, la pièce de micromécanique 101 comporte ainsi un corps 103 à base de silicium dont la paroi périphérique verticale 105 borde une surface supérieure horizontale 104 par l'intermédiaire d'une surface supérieure chanfreinée 106 et une surface inférieure horizontale 108 par l'intermédiaire d'une surface inférieure chanfreinée 109.

On comprend donc les surfaces supérieure et inférieure chanfreinées 106, 109 sensiblement rectiligne apportent une amélioration de la tenue mécanique notamment en réduisant la possibilité d'égrisures des angles sensiblement droits entre respectivement les parois périphériques et/ou internes verticales 105 et les surfaces supérieure ou inférieure horizontales 104, 108 de la pièce de micromécanique 101.

On comprend également que la paroi périphérique verticale 105 offre une réduction de sa surface de contact permettant d'apporter une amélioration quant à la tribologie contre une autre pièce ou quant à l'entrée d'un organe le long d'une paroi interne de la pièce de micromécanique.

Enfin, les décrochements des parois périphériques et/ou internes verticales 105 sont plus ouverts grâce aux surfaces supérieure et inférieure chanfreinées 106, 109 ce qui peut permettre notamment une augmentation de la capacité volumique à recevoir de la colle ou du lubrifiant comme dans le cas des décrochements 107 visibles à la figure 16 qui sont utilisés pour recevoir un matériau apte pour attacher une palette à l'ancre.

Le procédé de l'invention continue avec les étapes visibles en trait triple à la figure 18.

Ainsi, après la phase 22 de désoxydation du substrat 41, le procédé 11, selon le troisième mode de réalisation, se poursuit avec l'étape 29 destinée à remplir une cavité 53 formée lors des gravages 17, 19 et 27 de la pièce de micromécanique, formée par une surface supérieure chanfreinée, une paroi périphérique et une surface inférieure chanfreinée, d'un métal ou d'un alliage métallique afin d'offrir une attache à la pièce de micromécanique.

A titre d'exemple préféré, la couche inférieure 44 du substrat 41 est fortement dopée et utilisée comme base directe ou indirecte pour un remplissage par galvanoplastie. Ainsi, l'étape 29 pourrait comporter une première phase 30 destinée à former un moule, par exemple, en résine photosensible sur le dessus du masque 43 et dans une partie de la gravure 53. Une deuxième phase 32 pourrait consister à électroformer une partie métallique 112, à partir de la couche inférieure 44 au moins entre la pièce de micromécanique en silicium et une partie du moule formé dans la gravure 53. Enfin, une troisième phase 34 pourrait consister à retirer le moule formé lors de la phase 30.

Le procédé de l'invention se finit avec la phase 23 de libération de la pièce de micromécanique composite du substrat 41 par une attaque chimique sélective.

Le procédé 11 illustré en traits simple, double et triple à la figure 18 permet de s'affranchir des angles sensiblement droits entre respectivement les parois verticales périphériques et/ou internes gravées et les surfaces supérieure et inférieure horizontales du substrat 41 pour former une ou plusieurs pièces de micromécanique composite 111 formée(s) à base de silicium et de métal sur le même substrat 41.

On peut également s'apercevoir que le gravage oblique des étapes 17 et 27 autorise un angle largement plus ouvert et une direction de gravure sensiblement rectiligne qui évitent d'être limités par les paramètres d'un gravage ionique réactif profond du type « Bosch » et d'utiliser ce dernier lors de l'étape 19 selon ses paramètres optimisés de gravure verticale.

Avantageusement selon l'invention, la pièce de micromécanique composite, pouvant former une ancre comme dans l'exemple de la figure 16, comporte une nette amélioration esthétique en offrant un rendu beaucoup plus travaillé. En effet, en comparaison avec la figure 4, on peut immédiatement détecter le caractère travaillé de la pièce de micromécanique composite 111 aussi bien sur la face supérieure 104 que sur la face inférieure 108.

Comme mieux visible à la figure 17, la pièce de micromécanique composite 111 comporte ainsi un corps 103 à base de silicium dont la paroi périphérique verticale 105 borde une surface supérieure horizontale 104 par l'intermédiaire d'une surface supérieure chanfreinée 106 et, en outre, une surface inférieure horizontale 108 par l'intermédiaire d'une surface inférieure chanfreinée 109.

On comprend donc les surfaces supérieure et inférieure chanfreinées 106, 109 sensiblement rectiligne apportent une amélioration de la tenue mécanique notamment en réduisant la possibilité d'égrisures des angles sensiblement droits entre respectivement les parois périphériques et/ou internes verticales 105 et les surfaces supérieure ou inférieure horizontales 104, 108 de la pièce de micromécanique composite 111.

On comprend également que la paroi périphérique verticale 105 offre une réduction de sa surface de contact permettant d'apporter une amélioration quant à la tribologie contre une autre pièce. De plus, les décrochements des parois périphériques et/ou internes verticales 105 sont plus ouverts grâce aux surfaces supérieure et inférieure chanfreinées 106, 108 ce qui peut permettre notamment une augmentation de la capacité volumique à recevoir la partie en métal ou en alliage métallique comme, par exemple, les décrochements 107 visibles à la figure 16 qui pourrait être remplis lors du dépôt galvanique de l'étape 29. On comprend alors que le dépôt galvanique serait, par les formes des surfaces chanfreinées 106, 109 et des décrochements 107, impossibles à retirer et bénéficierait même d'une importante résistance au cisaillement.

Enfin, au moins une cavité 110 formant une paroi interne est au moins partiellement remplie d'un métal ou d'un alliage métallique 112 afin d'offrir une attache à la pièce de micromécanique composite 111. Ainsi, dans l'exemple de la figure 17, la cavité 110 pourrait laisser un évidement cylindrique 113 apte à permettre le chassage de la pièce de micromécanique composite 111 sur un organe comme, par exemple, un arbre, avec une très grande résistance mécanique lors du dudgeonnage de la partie en métal ou en alliage métallique 112 grâce aux formes des surfaces chanfreinées 106, 109 et, éventuellement, des décrochements 107.

Bien entendu, la présente invention ne se limite pas à l'exemple illustré mais est susceptible de diverses variantes et modifications qui apparaîtront à l'homme de l'art. En particulier, une étape d'oxydation 20, 28 destinée à lisser les parois en silicium peut être exécutée respectivement entre les étapes 19 et 21 ou entre les étapes 27 et 21.

De plus, la partie en métal ou en alliage métallique 112 pourrait déborder au-dessus de la gravure 53 lors de l'étape 29 de sorte à former un niveau fonctionnel supplémentaire de la pièce de micromécanique composite 111 qui serait alors uniquement formé en métal ou en alliage métallique.

Enfin, la pièce de micromécanique 101 ou la pièce de micromécanique composite 111 ne saurait se limiter à l'application d'une ancre comme visible à la figure 16. Ainsi, la pièce de micromécanique 101 ou la pièce de micromécanique composite 111 peut former tout ou partie d'un organe de mouvement ou d'habillage d'une pièce d'horlogerie.

A titre d'exemples nullement limitatifs, la pièce de micromécanique 101 ou la pièce de micromécanique composite 111 peut ainsi former tout ou partie d'un spiral, d'une cheville, d'un balancier, d'un axe, d'un plateau, d'une ancre comme une tige, une baguette, une fourchette, une palette et un dard, d'un mobile comme une roue, un arbre et un pignon, d'un pont, d'une platine, d'une masse oscillante, d'une tige de remontoir, d'un coussinet, d'un boîtier comme la carrure et les cornes, d'un cadran, d'un réhaut, d'une lunette, d'un poussoir, d'une couronne, d'un fond de boîtier, d'une aiguille, d'un bracelet comme un maillon, d'un décor, d'une applique, d'une glace, d'un fermoir, d'un pied de cadran, d'une tige de couronne ou d'une tige de poussoir.

## Revendications

1. Procédé (11) de fabrication d'une pièce de micromécanique (101, 111) à base de silicium comportant les étapes suivantes :
a) se munir d'un substrat (40) à base de silicium ;
b) former un masque (43) muni d'ajourages (45) sur une partie horizontale du substrat (40) ;
c) graver, dans une chambre de gravage, selon des parois (46) obliques prédéterminées, dans une partie de l'épaisseur du substrat (40) à partir des ajourages (45) du masque (43) afin de former des surfaces (106) supérieures chanfreinées de la pièce de micromécanique (101, 111);
d) graver, dans la chambre de gravage, selon des parois (47) sensiblement verticales, dans au moins une partie de l'épaisseur du substrat (40) à partir du fond de la première gravure (49) afin de former les parois périphériques (105) de la pièce de micromécanique (101, 111) sous les surfaces (106) supérieures chanfreinées ;
e) libérer la pièce de micromécanique (101, 111) du substrat (40) et du masque (43),
le procédé (11) comportant entre l'étape d) et l'étape e), les étapes suivantes :
f) former une couche (52) de protection sur les parois (46) obliques et les parois (47) sensiblement verticales en laissant le fond de gravure (51) de l'étape d) sans couche de protection ;
g) graver, dans la chambre de gravage, selon des parois (48) obliques prédéterminées, dans le reste de l'épaisseur du substrat (40) à partir du fond sans couche de protection afin de former des surfaces inférieures (109) chanfreinées de la pièce de micromécanique (101, 111), et **caractérisé**
**en ce que** le procédé (11) comporte avant l'étape e), l'étape suivante :
h) remplir une cavité (53) formée lors des gravages de la pièce de micromécanique (101, 111), formée par une surface (46) supérieure chanfreinée, une paroi (47) périphérique et une surface (48) inférieure chanfreinée, d'un métal ou d'un alliage métallique (112) afin d'offrir une attache à la pièce de micromécanique (101, 111).

2. Procédé (11) selon la revendication précédente, **caractérisé en ce que** l'étape c) est réalisée en mélangeant du gaz de gravage et du gaz de passivation dans la chambre de gravage afin de former des parois (46) obliques.

3. Procédé (11) selon la revendication précédente, **caractérisé en ce que**, lors de l'étape c), les flux continus des gaz de gravage et de passivation sont pulsés afin de favoriser la passivation en fond de cavité.

4. Procédé (11) selon l'une des revendications précédentes, **caractérisé en ce que** l'étape d) est réalisée en alternant un flux de gaz de gravage et un flux de gaz de passivation dans la chambre de gravage afin de former des parois (47) sensiblement verticales.

5. Procédé (11) selon la revendication précédente, **caractérisé en ce que** l'étape g) est réalisée en mélangeant du gaz de gravage et du gaz de passivation dans la chambre de gravage afin de former des parois (48) obliques.

6. Procédé (11) selon la revendication précédente, **caractérisé en ce que**, lors de l'étape g), les flux continus des gaz de gravage et de passivation sont pulsés afin de favoriser le gravage en fond de cavité.

7. Procédé (11) selon l'une des revendications 5 à 7, **caractérisé en ce que** l'étape f) comporte les phases suivantes :
f1) oxyder les parois (46) obliques et les parois (47) sensiblement verticales pour former la couche (52) de protection en oxyde de silicium ;
f2) graver de manière directionnelle la couche (52) de protection afin de retirer sélectivement la partie de couche de protection (52) uniquement au niveau du fond de gravure (51) de l'étape d).

## Patentansprüche

1. Verfahren (11) zur Herstellung eines mikromechanischen Werkstücks (101, 111) auf der Basis von Silizium, das die folgenden Schritte aufweist:
a) Bereitstellen eines Substrats (40) auf der Basis von Silizium;
b) Formen einer Maske (43) mit Durchbrüchen (45) auf einem horizontalen Teil des Substrats (40);
c) Gravieren, in einer Gravierkammer gemäß vorher festgelegten schrägen Wänden (46) in einen Teil der Dicke des Substrats (40) ausgehend von den Durchbrüchen (45) der Maske (43), um abgefaste obere Flächen (106) des mikromechanischen Werkstücks (101, 111) zu bilden;
d) Gravieren in der Gravierkammer gemäß etwa vertikalen Wänden (47) in mindestens einen Teil der Dicke des Substrats (40) ausgehend vom Boden der ersten Gravur (49), um periphere Wände (105) des mikromechanischen Werkstücks (101, 111) unter den abgefasten oberen Flächen (106) zu bilden;
e) Freigeben des mikromechanischen Werkstücks (101, 111) aus dem Substrat (40) und der Maske (43),
wobei das Verfahren (11) zwischen dem Schritt d) und dem Schritt e) die folgenden Schritte aufweist:
f) Bilden einer Schutzschicht (52) auf den schrägen Wänden (46) und den etwa vertikalen Wänden (47), wobei der Gravierboden (51) von Schritt d) ohne Schutzschicht bleibt;
g) Gravieren in der Gravierkammer gemäß vorher festgelegten schrägen Wänden (48) in die verbliebene Dicke des Substrats (40) ausgehend vom Boden ohne Schutzschicht, um abgefaste untere Flächen (109) des mikromechanischen Werkstücks (101, 111) zu bilden, und
**dadurch gekennzeichnet, dass** das Verfahren (11) vor dem Schritt e) den folgenden Schritt aufweist:
h) Füllen eines beim Gravieren des mikromechanischen Werkstücks (101, 111) gebildeten Hohlraums (53), der von einer abgefasten oberen Fläche (46), einer peripheren Wand (47) und einer abgefasten unteren Fläche (48) gebildet wird, mit einem Metall oder einer Metalllegierung (112), um dem mikromechanischen Werkstück (101, 111) eine Halterung zu bieten.

2. Verfahren (11) nach vorangehendem Anspruch, **dadurch gekennzeichnet, dass** der Schritt c) durch Mischen von Graviergas und Passivierungsgas in der Gravierkammer durchgeführt wird, um schräge Wände (46) zu bilden.

3. Verfahren (11) nach vorangehendem Anspruch, **dadurch gekennzeichnet, dass** bei Schritt c) die kontinuierlichen Gravier- und Passivierungsgasströme gepulst werden, um die Passivierung am Boden des Hohlraums zu fördern.

4. Verfahren (11) nach einem der vorangehenden Ansprüche, **dadurch gekennzeichnet, dass** der Schritt d) durch Abwechseln eines Graviergasstroms und eines Passivierungsgasstroms in der Gravierkammer durchgeführt wird, um etwa vertikale Wände (47) zu bilden.

5. Verfahren (11) nach vorangehendem Anspruch, **dadurch gekennzeichnet, dass** der Schritt g) durch Mischen des Graviergases und des Passivierungsgases in der Gravierkammer durchgeführt wird, um schräge Wände (48) zu bilden.

6. Verfahren (11) nach vorangehendem Anspruch, **dadurch gekennzeichnet, dass** bei Schritt g) die kontinuierlichen Gravier- und Passivierungsgasströme gepulst werden, um das Gravieren am Boden des Hohlraums zu fördern.

7. Verfahren (11) nach einem der Ansprüche 5 bis 7, **dadurch gekennzeichnet, dass** der Schritt f) die folgenden Phasen aufweist:
f1) Oxidieren der schrägen Wände (46) und der etwa vertikalen Wände (47), um die Schutzschicht (52) aus Siliziumoxid zu bilden;
f2) direktionelles Gravieren der Schutzschicht (52), um den Teil der Schutzschicht (52) nur im Bereich des Gravierbodens (51) von Schritt d) selektiv zu entfernen.

## Claims

1. Method (11) for fabricating a micromechanical component (101, 111) made of a silicon-based material comprising the following steps:
a) taking a silicon-based substrate (40);
b) forming a mask (43) pierced with holes (45) on a horizontal portion of the substrate (40);
c) etching, in an etching chamber, predetermined oblique walls (46), in part of the thickness of the substrate (40), from holes (45) in the mask (43), in order to form upper chamfered surfaces (106) of the micromechanical component (101, 111);
d) etching, in the etching chamber, substantially vertical walls (47), in at least part of the thickness of the substrate (40), from the back of the first etch (49), in order to form the peripheral walls (105) of the micromechanical component (101, 111) beneath the upper chamfered surfaces (106);
e) releasing the micromechanical component (101, 111) from the substrate (40) and the mask (43),
the method including, between step d) and step e), the following steps:
f) forming a protective layer (52) on the oblique walls (46) and the substantially vertical walls (47), leaving the back of the etch (51) made in step d) without any protective layer;
g) etching, in the etching chamber, predetermined oblique walls (48), in the remaining thickness of the substrate (40) from the bottom without any protective layer, in order to form lower chamfered surfaces (109) of the micromechanical component (101, 111),
and **characterised in that** the method (11) includes, before step e), the following step:
h) filling a cavity (53) created during the etchings of the micromechanical component (101, 111), formed by an upper chamfered surface (46), a peripheral wall (47) and a lower chamfered surface (48), with a metal or metal alloy (112) in order to provide an attachment to the micromechanical component (101, 111).

2. Method (11) according to the preceding claim, **characterised in that** step c) is achieved by mixing the etching gas and the passivation gas in the etching chamber in order to form oblique walls (46).

3. Method (11) according to the preceding claim, **characterised in that**, in step c), the continuous etching and passivation gas flows are pulsed to enhance the passivation at the cavity back.

4. Method (11) according to one of the preceding claims, **characterised in that** step d) is achieved by alternating an etching gas flow and a passivation gas flow in the etching chamber in order to form substantially vertical walls (47).

5. Method (11) according to the preceding claim, **characterised in that** step g) is achieved by mixing the etching gas and the passivation gas in the etching chamber in order to form oblique walls (48).

6. Method (11) according to the preceding claim, **characterised in that**, in step g), the continuous etching and passivation gas flows are pulsed to enhance the etching at the cavity back.

7. Method (11) according to one of claims 5 to 7, **characterised in that** step f) comprises the following phases:
f1) oxidising the oblique walls (46) and the substantially vertical walls (47) to form the protective silicon oxide layer (52);
f2) directionally etching the protective layer (52) in order to selectively remove only the portion of the protective layer (52) from the back of the etch (51) made in step d).
